# EUROPÄISCHE PATENTSCHRIFT

(11) **EP 2 171 750 B1**
(45) Veröffentlichungstag und Bekanntmachung des Hinweises auf die Patenterteilung: **11.09.2013**
(21) Anmeldenummer: 08774671.5
(22) Anmeldetag: 02.07.2008
(51) Int. Cl.: H01L 21/3065, H01L 21/3213, B81C 1/00, B01J 19/08

(54) **VERFAHREN ZUM ÄTZEN EINER SCHICHT AUF EINEM SILIZIUM-HALBLEITERSUBSTRAT**
METHOD FOR ETCHING A LAYER OF A SILICON SEMICONDUCTOR SUBSTRATE
PROCÉDÉ DE GRAVURE D'UNE COUCHE APPLIQUÉE SUR UN SUBSTRAT SEMI-CONDUCTEUR EN SILICIUM

(30) Priorität: 19.07.2007 DE 102007033685
(43) Veröffentlichungstag der Anmeldung: 07.04.2010
(73) Patentinhaber: Robert Bosch GmbH, 70442 Stuttgart (DE)
(72) Erfinder: BECKER, Volker, 76359 Marxzell (DE); LAERMER, Franz, 71263 Weil Der Stadt (DE); FUCHS, Tino, 72076 Tuebingen (DE); LEINENBACH, Christina, 66806 Ensdorf (DE)
(86) Internationale Anmeldenummer: PCT/EP2008/058539
(87) Internationale Veröffentlichungsnummer: WO 2009/010391

(56) Entgegenhaltungen:
- WO-A-2004/002882
- WO-A-2006/013137
- LEINENBACH C ET AL: "A novel sacrificial layer technology based on highly selective etching of silicon-germanium in ClF3" 2007 20TH IEEE INTERNATIONAL CONFERENCE ON MICRO ELECTRO MECHANICAL SYSTEMS - MEMS '07 IEEE PISCATAWAY, NJ, USA, 2007, Seiten 65-68, XP002495538 ISBN: 978-1-4244-0950-1

## Beschreibung

### Stand der Technik

Die vorliegende Erfindung betrifft ein Verfahren zum Ätzen einer SiGe-Mischhalbleiterschicht auf einem Silizium-Halbleitersubstrat durch trockenchemisches Ätzen.

Bei der Herstellung von Halbleiterbauelementen, insbesondere bei der Fertigung freitragender Sensorstrukturen in der Oberflächenmikromechanik, ist eine selektive Entfernung einer bestimmten Schicht, einer so genannten Opferschicht, selektiv zur Funktionsschicht eine häufig notwendige Maßnahme. Grundsätzlich kann eine solche Opferschicht trockenchemisch oder nasschemisch entfernt werden. Bevorzugt werden Opferschichten mittels gasförmiger Ätzmedien entfernt, da bei der Verwendung von Ätzgasen die Gefahr des irreversiblen Verklebens von Sensorstrukturelementen und darunter liegendem Siliziumsubstrat oder von Teilen der Sensorstrukturelemente untereinander, das so genannte Sticking-Risiko deutlich vermindert ist oder nicht besteht.

Bei der Herstellung mikromechanischer Strukturen oder Bauteile dient zumeist Silizium aufgrund der für diese Anwendungen hervorragenden Eigenschaften als funktionelle Schicht. Häufig wird einkristallines Silizium oder polykristallines Silizium, insbesondere so genanntes EpiPolysilizium, das ist epitaktisch abgeschiedenes polykristallines Silizium, als Sensorfunktionsschicht, aus der die Sensorstrukturelemente heraus strukturiert werden, verwendet. In Verbindung mit Sensorstrukturelementen aus Silizium ist ein besonders geeignetes Opferschichtmaterial Silizium-Germanium (SiGe).

Ein bevorzugtes Ätzgas in plasmalosen trockenchemischen Ätzprozessen ist Chlortrifluorid (ClF₃). Chlortrifluorid wird üblicherweise in Druckgasflaschen, die die Substanz in verflüssigter Form beinhalten, bevorratet. Da die Flüssigkeit ClF₃ äußerst reaktiv und als starkes Oxidationsmittel sehr gefährlich ist, und bei einer ungewollten Freisetzung große Schäden anrichten kann, wird Chlortrifluorid trotz seiner vorteilhaften Eigenschaften von vielen Nutzern gemieden.

Die Schrift DE 102 29 037 A1 offenbart ein Verfahren und eine Vorrichtung, mit der ClF₃ mittels einer hochdichten Downstream-Plasmaanregung vor dem eigentlichen Ätzvorgang aus vergleichsweise harmlosen Gasen wie Chlor oder HCl einerseits und Schwefelhexafluorid, Stickstofftrifluorid oder Fluor andererseits hergestellt und nachfolgend einer Prozesskammer, in der das Ätzen durchgeführt wird, zugeführt wird.

Nachteilig bei bekannten Ätzverfahren ist, dass die erreichbare Selektivität des Ätzens von Silizium-Germanium gegenüber Silizium die Herstellung komplexer Strukturen und Geometrien in der Halbleitertechnologie unter gezielter Entfernung von Materialien, insbesondere einer gezielten Entfernung von Opferschichten, beispielsweise in Schichtstapeln, bei Herstellungsverfahren von Halbleiterbauelementen beschränkt.

Die Schrift WO 2004/002882 A offenbart eine Vorrichtung, wobei eine Vorrichtung zur Erzeugung von Chlortrifluorid mit einem Plasmareaktor verbunden ist.

### Offenbarung der Erfindung

Das erfindungsgemäße Verfahren zum Ätzen einer SiGe-Mischhalbleiterschicht auf einem Silizium-Halbleitersubstrat durch trockenchemisches Ätzen der SiGe-Mischhalbleiterschicht mittels eines Ätzgases ausgewählt aus der Gruppe umfassend ClF₃ und/oder ClF₅, hat den Vorteil, dass eine Steigerung der Selektivität der Ätzung von Silizium-Germanium gegenüber Silizium im trockenchemischen Ätzverfahren zur Verfügung gestellt werden kann.

Dies ermöglicht, dass bestehende Siliziumstrukturen oder funktionale dielektrische Schichten mit verminderten oder sogar ohne weitere Schutzmaßnahmen durch Ätzen von Silizium-Germanium-Opferschichten freigelegt werden können. Es ist von Vorteil, dass Silizium-Germanium selektiv geätzt werden kann, wobei eine Passivierung von Siliziumfunktionsstrukturen nicht erforderlich ist.

Dies wird erfindungsgemäß dadurch erreicht, dass man dem Ätzgas ein Gas ausgewählt aus der Gruppe umfassend Cl₂ und/oder HCl zusetzt.

Für alle denkbaren Siliziummaterialien wird nachfolgend der Begriff "Silizium" oder "Si" durchgehend und ohne weitere Unterscheidung verwendet. Entsprechend wird nachfolgend der Begriff "Silizium-Germanium" oder "SiGe" für alle denkbaren Arten von SiGe, polykristallines oder einkristallines SiGe und unabhängig von der Art der Abscheidung und den Mischungsverhältnissen von Silizium und Germanium, durchgehend verwendet.

Es konnte überraschend festgestellt werden, dass ein Zusatz von Chlor und/oder HCl zu dem Ätzgas bei gleich bleibendem Partialdruck des Ätzgases einen verringerten Ätzangriff auf Silizium bewirkt, ohne dass die Ätzrate von Silizium-Germanium nachteilig beeinflusst wird. Durch die Verminderung der unerwünschten Ätzung von Silizium gegenüber Silizium-Germanium ermöglicht das erfindungsgemäße Verfahren ein Opferschichtätzen, wobei beispielsweise noch dünnere oder kritischer dimensionierte Silizium-Funktionselemente herstellbar sind. Dies ermöglicht die Herstellung bislang kritischer Designgeomctrien, insbesondere können weiter verkleinerte mikromechanische Strukturen, insbesondere Sensorstrukturen, freigelegt werden.

Von besonderem Vorteil ist, dass Opferschichten beispielsweise aus Silizium-Germanium entfernt werden können, ohne funktionale Strukturelemente aus Silizium oder andere funktionale, auf Silizium basierende Schichten wie Siliziumnitrid oder Siliziumoxid, merklich anzuätzen.

Die durch das erfindungsgemäße Verfahren erzielbare erhöhte Selektivität ermöglicht in vorteilhafter Weise, dass größere Unterätzweiten erzielt werden können. Weiterhin ermöglicht das erfindungsgemäße Verfahren, dass die Ätzrate von Silizium-Germanium erhöht werden kann, beispielsweise durch höhere Prozessdrücke, ohne dass dank der erhöhten Selektivität des Verfahrens Siliziumstrukturelemente nennenswert angegriffen werden. Dies ermöglicht weiter verbesserte Unterätzweiten und/oder verkürzte Prozesszeiten.

Von großem Vorteil ist, dass insbesondere sehr kleine oder sehr schmale oder auch flächig sehr ausgedehnte Siliziumstrukturen freigelegt werden können, da eine schnelle und sehr selektive Ätzung zur Verfügung gestellt werden kann.

### Zeichnungen

Ausführungsbeispiele der Erfindung sind in den Zeichnungen dargestellt und werden in der nachfolgenden Beschreibung näher erläutert. Hierbei zeigt:

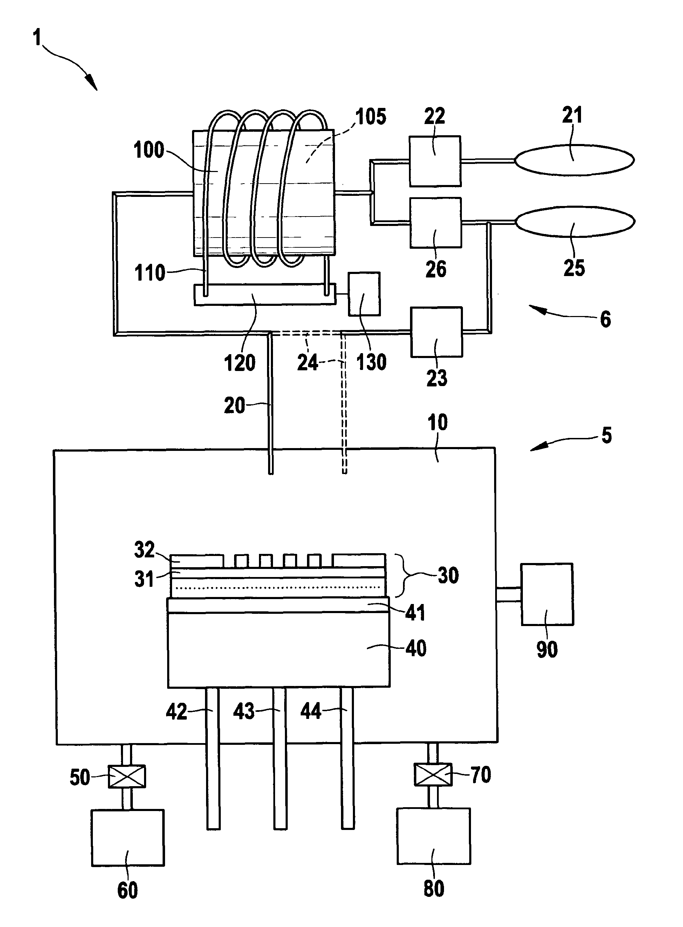

- Figur 1: eine Prinzipskizze einer Anlage zur Ätzung eines Halbleitersubstrats mit einer Vorrichtung zur Erzeugung von Chlortrifluorid mittels hochdichter Plasmaanregung.

Das erfindungsgemäße Verfahren wird zunächst beispielhaft in Zusammenhang mit einer in-situ-Erzeugung von ClF₃ erläutert.

In der Figur 1 ist eine Vorrichtung 1 umfassend eine Ätzanlage 5 dargestellt, die eine Prozesskammer 10 aufweist, in der ein Halbleitersubstrat 30, vorzugsweise ein Siliziumwafer, der eine Silizium-Germanium-Mischhalbleiterschicht 31 aufweist, geätzt wird. Die Ätzanlage 5 ist mit einer Vorrichtung 6 zur Erzeugung von Chlortrifluorid (ClF₃) versehen. Anlagen, verbunden mit Vorrichtungen zur Erzeugung von Chlortrifluorid sind in der Patentschrift DE 102 29 037 A1 offenbart, auf die hiermit Bezug genommen wird. Die in der Patentschrift DE 102 29 037 A1 offenbarte und mit einer Vorrichtung zur Erzeugung von Chlortrifluorid versehene Anlage unterscheidet sich von der erfindungsgemäß offenbarten Anlage darin, dass keine Mittel vorgesehen sind, die erlauben, dem hergestellten Ätzgas, beispielsweise Chlortrifluorid, Gase ausgewählt aus der Gruppe umfassend Cl₂ und/oder HCl, zusätzlich zuzusetzen. Die Anlage 5 bzw. Vorrichtung 6 wurde erfindungsgemäß entsprechend modifiziert, indem die Möglichkeit geschaffen wurde, dem Ätzgas, beispielsweise Chlortrifluorid, ein Gas ausgewählt aus der Gruppe umfassend Cl₂ und/oder HCl zusätzlich zuzusetzen, beispielsweise durch zuführung in den Gasauslass 20 und/oder die Prozesskammer 10.

Im Rahmen einer besonders bevorzugten Ausführungsform wurde dem Plasmareaktor 100, dem ein erstes und ein zweites Gas, so genannte "Precursorgase" zugeführt werden als erstes Gas Cl₂ und/oder HCl und als zweites Gas NF₃ zugeführt. Hierbei reagieren beispielsweise Stickstofftrifluorid und Chlor im Plasma zu Chlortrifluorid gemäß der nachstehenden stöchiometrischen Reaktion: 2 NF₃ + Cl₂ → N₂ + 2 ClF₃ bzw. Stickstofftrifluorid und HCl gemäß nachstehender stöchiometrischer Reaktion: 4 NF₃ + 3 HCl → 3 ClF₃ + 3 HF + 2 N₂.

Im Rahmen der vorliegenden Erfindung ist unter dem Begriff "stöchiometrisch" das Mischungsverhältnis, das der Reaktionsgleichung zur Bildung des gewünschten Endprodukts entspricht, zu verstehen. Der Begriff "stöchiometrisch" wird nachfolgend insbesondere bezogen auf die Bildungsreaktion von ClF₃ oder übertragen auf ClF₅ verwendet.

Hierzu wird zunächst das Gas NF₃ aus einem ersten Gasreservoir 21, beispielsweise einer Gasflasche, und das Gas Cl₂ oder HCl aus einem zweiten Gasreservoir 25, beispielsweise einer Gasflasche, über einen zugeordneten ersten Massenflussregler 22 bzw. einen zugeordneten zweiten Massenflussregler 26 entnommen und dem Plasmareaktor 100 zugeführt. Hierin kann durch hochdichte Plasmaanregung der zugeführten Precursurgase und durch Umsetzung der Plasmabruchstücke zu ClF₃ sowie N₂ und, im Fall von HCl, auch HF erzeugt werden, welches über den Gasauslauf 20, der Prozesskammer 10 zur Ätzung des Halbleitersubstrats 30 zugeführt wird. Die Herstellung des induktiven Plasmas 105 kann, wie in der Figur 1 angedeutet, vorzugsweise über eine induktive Spule 110 verbunden mit einem Anpassnetzwerk 120 und einem Hochfrequenzgenerator 130 oder über ein Mikrowellenfeld beispielsweise über Verwendung eines Hohlleiters erreicht werden.

Die Prozesskammer 10 weist eine Substratelektrode 40 auf, auf der ein Siliziumwafer als Halbleitersubstrat 30 geklemmt werden kann.

Bevorzugt erfolgt diese Klemmung über eine Klemmeinrichtung 41, beispielsweise einen elektrostatischen Chuck, durch die auch die aufliegende Seite des Halbleitersubstrates 30 vor den Gasen in der Prozesskammer 10 geschützt ist. Die aufliegende Seite des Halbleitersubstrates 30 wird ferner bevorzugt mit He beaufschlagt, um eine gute thermische Anbindung an die Substratelektrode 41 und eine zusätzliche Isolation gegen die Gase der Prozesskammer 10 zu erreichen. Die Substratelektrode 40 weist ferner elektrische Zuführungen bzw. Abführungen 42 für die Klemmeinrichtung 41 und eine gegebenenfalls vorgesehene elektrische Heizung auf, die in der Substratelektrode 41 zur Temperaturkontrolle bzw. Temperatureinstellung vorgesehen sein kann. Bevorzugt können über die elektrischen Zuführungen bzw. Abführungen 42 auch Messdaten nach Außen übertragen werden, beispielsweise die Elektrodentemperatur oder der Heliumrückseitendruck. Des weiteren weist die Substratelektrode 40 eine Gaszufuhr bzw. Gasabfuhr 43 auf, über die vorzugsweise He als Konvektionsmedium zur Kühlung des Halbleitersubstrates 30 mit einem einstellbaren Druck zu- bzw. abführbar ist. Eine weitere Zufuhr bzw. Abfuhr 44 erlaubt die Zirkulation eines Kältemittels durch die Substratelektrode 40, um deren Temperatur einzustellen und insbesondere eine auf dem Halbleitersubstrat 30 entstehende Reaktionswärme aus einer exothermen Ätzreaktion abzuführen. Die Substrattemperatur beträgt bevorzugt -30°C bis 30°C für optimale Ätzbedingungen und Maskenselektivität. Es konnte festgestellt werden, dass eine sehr gute Selektivität oder sogar die höchste Selektivität bei Temperaturen im Bereich von ≥ 18°C bis ≤ 30°C, vorzugsweise im Bereich von ≥ 18°C bis ≤ 25°C, bevorzugt bei Temperaturen um 20°C erreichbar ist. Als Kältemittel können Fluorinert® oder Glykol-Wassergemische eingesetzt werden.

Die Prozesskammer 10 weist eine erste Pumpe 60, insbesondere eine Turbomolekularpumpe, und eine zweite Pumpe 80, insbesondere eine Drehschieberpumpe, auf, die in dem Sinne gekoppelt sein können, dass die Drehschieberpumpe 80 zeitweise oder auch permanent als Vorpumpe für die Turbomolekularpumpe 60 dienen kann. Die Drehschieberpumpe 80, die vorzugsweise als Trockenläuferpumpe ausgeführt ist, dient zum "Roughing" der ganzen Anlage 5 nach einem Belüften und als Prozesspumpe, um die Prozessgase während der Durchführung eines Ätzprozesses abzupumpen. Zur Druckregelung dient ein Regelventil 70. Die Druckmessung geschieht über einen Druckmesser 90, der als Baratron bzw. als kombiniertes Baratron und Ionivac ausgeführt sein kann. Druckmesser 90 und Regelventil 70 werden dazu benützt, den gewünschten Prozessdruck während der Prozessierung des Halbleitersubstrates 30 stabil einzustellen. Die Turbopumpe 60 in Verbindung mit einem Absperrventil 50 dient dazu, vor und nach der Prozessierung ein möglichst gutes Endvakuum zu erreichen, beispielsweise besser als 10⁻⁴ Pa. Während des Prozesses kann die Turbopumpe 60 in einer Ausführungsform der Anlage über das Absperrventil 50 von der Prozesskammer 10 abgetrennt werden, da sie bei Prozessdrücken im mbar-Bereich nicht einsetzbar ist und ein Kontakt mit den aggressiven Prozessgasen so vermieden werden kann. Sollen Prozessdrücke < 1 mbar verwendet werden, so ist es selbstverständlich auch möglich die Turbomolekularpumpe während des Prozesses durchgängig zu nutzen, um diese niedrigen Prozessdrücke während des gesamten Prozesses halten zu können.

Das Halbleitersubstrat 30 weist eine Silizium-Germanium-Schicht 31 auf sowie eine darüber liegende Siliziumfunktionsschicht 32. Geeignet sind sowohl polykristalline als auch einkristalline Silizium-Germanium-Schichten, die auch epitaktisch abgeschieden werden können. Als Funktionsschicht werden insbesondere epitaktisch abgeschiedene Poly-Silizium-Schichten bevorzugt, so genanntes EpiPolySilizium. Es kann auch einkristallines Silizium epitaktisch über einkristallines SiliziumGermanium abgeschieden werden. Erfindungsgemäß wird durch das trockenchemische Ätzen die SiGe-Schicht unter Verwendung von ClF₃ als Ätzgas, dem ein weiteres Gas aus der Gruppe umfassend Cl₂ und/oder HCl zugesetzt wird, selektiv gegenüber der Siliziumfunktionsschicht 32 und dem darunter liegenden Siliziumhalbleitersubstrat 30 entfernt.

Das Zusetzen von Cl₂ und/oder HCl wird über einen weiteren Massenflussregler 23 und/oder den Massenflussregler 26 gesteuert.

In einer ersten Ausführungsform wird das Gas ausgewählt aus der Gruppe umfassend Cl₂ und/oder HCl dem Ätzgas dadurch zugesetzt, dass ein Überschuss des ersten Gases Cl₂ und/oder HCl gegenüber dem zweiten Gas, vorzugsweise NF₃, dem Plasmareaktor 100 zugeführt wird. Dieser über dem stöchiometrischen Verhältnis für die ClF₃-Erzeugung liegende Chlor- oder HCl-Anteil wird über den Massenregler 26 gesteuert. Bei dieser Ausführungsform ist insbesondere von Vorteil, dass bei der Bildung von ClF₃ aus NF₃ unter Plasmaanregung in dem Plasmareaktor 100 durch den zugesetzten Chlorüberschuss während der Reaktion gebildete freie Fluorradikale vollständig oder nahezu vollständig mit dem Chlorüberschuss abreagieren können. Dies hat den großen Vorteil zur Folge, dass keine oder nahezu keine Fluorradikale ungebunden die Prozesskammer erreichen, wo sie die Selektivität einer Opferschichtätzung einer Silizium-Germanium-Schicht gegenüber Silizium äußerst nachteilig beeinflussen würden, da sie Silizium-Germanium wie Silizium ohne Unterschied ätzen. Dies ist insbesondere von Vorteil, da Fluorradikale in Gasform eine relativ lange Lebensdauer und eine große Reichweite haben, so dass diese aus dem Plasmareaktor 100 die Prozesskammer 10 erreichen könnten.

Unter Plasmaanregung aus Cl₂ oder HCl gebildete Chlorradikale weisen im Gegensatz zu Fluorradikalen nur eine sehr kurze Lebensdauer im Gasraum auf und haben infolgedessen nur eine kurze Reichweite. Diese erreichen die Prozesskammer 10 nicht in Form von Radikalen, sondern überwiegend in Form von Chlormolekülen Cl₂ oder Interlialogeniden der Form CIF. ClF weist sowohl gegenüber Silizium als auch gegenüber Silizium-Germanium nur sehr geringe Reaktionsraten auf, so dass es im allgemeinen bei dem erfindungsgemäßen Trockenätzen mit Ätzgasen wie ClF₃ für das SiGe-Schicht-Ätzcn als neutral betrachtet werden kann. Ebenfalls kann unter Plasmaanregung entstehender Stickstoff für das Trockenätzen als unbeachtlich betrachtet werden, da das Inertgas Stickstoff ebenso wie Argon keinen signifikanten Einfluss auf die Selektivität des Ätzvorgangs aufweist.

In einer bevorzugten Ausführungsform wird das Gas ausgewählt aus der Gruppe umfassend Cl₂ und/oder HCl dem gebildeten Chlortrifluorid zugeführt, vorzugsweise erst unterhalb dies Plasmareaktors 100. Diese Zufuhr wird über den Massenregler 23 gesteuert. Hierbei ist bevorzugt, dass Chlor und/oder HCl dem gebildeten Chlortrifluorid zugesetzt werden, indem diese gesteuert über den Massenregler 23 in den Gaseinlass 20 zugeführt werden. In dieser Ausführungsform erreichen das gebildete ClF₃ sowie das zugesetzte Chlor und/oder HCl die Prozesskammer 10 durch eine gemeinsame Zuführung durch den Gaseinlass 20.

Als besonderer Vorteil der zweiten Ausführungsform einer gemeinsamen Zuführung des gebildeten ClF₃ und etwaiger weiterer in dem Plasmareaktor 100 entstehender Reaktionsprodukte und des zugesetzten Chlorgases und/oder Chlorwasserstoffs in die Prozesskammer 10 ist hervorzuheben, dass unerwünschte freie Fluorradikale aus dem Plasmareaktor 100 durch das Zusetzen von Chlor oder HCl auf dem Weg von dem Plasmareaktor 100 zu der Prozesskammer 10 durch den Gaszulass 20 abgefangen werden können. Ebenso wie Chlor fängt auch HCl Fluor in einer "Titrationsreaktion" ab, wobei HF und ClF gebildet werden.

Bei dieser zweiten Ausführungsform ist bevorzugt, dass die Herstellung des ClF₃ unter Verwendung von Chlor oder HCl in dem Plasmareaktor 100 unter stöchiometrischen oder nahezu stöchiometrischen Bedingungen, d.h. in einem für die Erzeugung von ClF₃ stöchiometrischen Verhältnis von NF₃ und Cl₂ oder HCl zueinander, durchgeführt wird.

Dies kann den Vorteil zur Verfügung stellen, dass durch ein annähernd stöchiometrisches Verhältnis von NF₃ zu Cl₂ bezogen auf die ClF₃-Bildungreaktion, vorzugsweise von ca. 2:1, oder von NF₃ zu HCl von vorzugsweise ca. 4:3, vermieden werden kann, dass ein zu großer Anteil von Fluorradikalen anstatt zu ClF₃ zu ClF reagiert, welches als Ätzgas für eine Opferschichtätzung ineffektiv wäre. Weiterhin kann durch eine Herstellung von ClF₃ unter stöchiometrischen oder nahezu stöchiometrischen Bedingungen vermieden werden, dass im Plasma Chlorradikale im Übermaß generiert werden und ein Teil der zur Verfügung gestellten Plasmaleistung für die Bildung von Chlorradikalen verbraucht würde, wobei diese für das Trockenätzen keinen Nutzen erzeugen, da diese aufgrund Ihrer kurzen Lebensdauer einer Rückbildung zu Cl₂ oder einer Reaktion zu nutzlosen Interhalogeniden wie ClF unterliegen.

In einer weiteren Ausführungsform kann das Zusetzen von Chlor und/oder HCl erfolgen, indem Chlor und/oder HCl der Prozesskammer 10 über eine unabhängige Zuführung 24 zugeführt werden.

Es kann besonders bevorzugt sein, die Möglichkeiten zum Zusetzen von Cl₂ und/oder HCl zu dem Ätzgas zu kombinieren. Beispielsweise kann in dem Plasmareaktor 100 ein vorzugsweise nur wenig über dem stöchiometrischen Verhältnis für die Erzeugung von ClF₃ liegender Chloranteil eingestellt werden. Hierbei kann in vorteilhafter Weise bereits bei der Erzeugung von ClF₃ das Entstehen von Fluorradikalen vermindert oder verhindert werden. Weiterhin kann dem Ätzgas ClF₃ zusätzlich ein zweiter Chlorgasstrom über den Massenflussregler 23 in die Gaszuleitung 20 und/oder über eine separate Zuleitung 24 direkt in die Prozesskammer zugesetzt werden.

Der Gesamtgasdruck während des Ätzvorgangs in der Prozesskammer 10 ist über die Drucksteuerung der Ätzanlage 6, insbesondere ein Regelventil 70 und einen Druckmesser 90, einstellbar.

Vorzugsweise liegt der Gesamtdruck von Ätzgas und zugesetztem Gas im Bereich von > 0,5 Pa bis ≤ 1000 Pa, bevorzugt, im Bereich von ≥ 1 Pa bis ≤ 200 Pa, besonders bevorzugt im Bereich von ≥ 20 Pa bis ≤ 100 Pa.

Für die Umsetzung zu ClF₃ liegt das Verhältnis der Gasflüsse von NF₃ zu Cl₂ vorzugsweise bei etwa 2:1, das Verhältnis der Gasflüsse von NF₃ zu HCl vorzugsweise bei etwa 4:3.

Die Gasflüsse der Precursorgase NF₃ und Cl₂ oder HCl in den Plasmareaktor 100 liegen vorzugsweise im Bereich von ≥ 100 sccm bis ≤ 1 slm NF₃ und im Bereich von ≥ 50 sccm bis ≤ 500 sccm Cl₁ und/oder ≥ 75 sccm bis ≤ 750 sccm HCl.

### Ausführungsbeispiel

In einer Anlage 5, wie anhand von Figur 1 dargestellt, wurde gemäß dem erfindungsgemäßen Verfahren eine SiGe-Mischhalbleiterschicht 31 einer Dicke von 2500 nm auf einem Silizium-Halbleitersubstrat 30 durch trockenchemisches plasmaloses Ätzen entfernt.

Wie in der DE 102 29 037 A1 offenbart, erfolgte der Ätzvorgang indem ein Siliziumwafer zunächst in die Ätzanlage 6 eingeschleust und auf der Substratelektrode 40 geklemmt wurde. Die Turbopumpe 60 pumpte nun so lange die Kammer 10 und die daran angeschlossene Mimik der Gasversorgung mit dem Plasmareaktor 100, bis das gewünschte Basisvakuum erreicht war. Während des gesamten Prozesses pumpte die Turbomolekularpumpe mit der Drehschieberpumpe als Vorpumpe die Prozesskammer. Mittels der Massenflussregler 22, 26 wurden nun die gewünschten Mengen der Prozessgase zugeführt. Außerdem wurde die Plasmareaktion in dem Plasmareaktor 100 nach Stabilisierung der Gasflüsse durch Einschalten des Hochfrequenzgenerators 130 an die induktive Plasmaquelle bzw. die Spule 110 gestartet. Der Druck in der Prozesskammer 10 und damit auch in dem vorgeschalteten Plasmareaktor 100 wurde mittels des Druckmessers 90 gemessen und mittels der Kombination aus Drehschieberpumpe 80 und Regelventil 70 auf dem gewünschten Wert stabilisiert.

Der Siliziumwafer wurde dann durch die Zufuhr des in dem Plasmareaktor 100 aus den Precursorgasen generierten ClF₃ sowie des erfindungsgemäß zusätzlich zugesetzten Cl₂ geätzt. Hierzu wurde unter Plasmaanregung in situ ClF₃ aus den Precursurgasen NF₃ und Cl₂ hergestellt, die mit einem Gasfluss von 150 sccm NF₃ und 80 sccm Cl₂ verwendet wurden. Das hergestellte ClF₃ wurde der Prozesskammer mit einem ClF₃-Partialdruck von 27 Pa als konstanten Parameter zugeleitet. Zusätzliches Chlorgas wurde dem gebildeten Chlortrifluorid über den Massenregler 23 in den Gaseinlass 20 zugeführt. Hierbei wurden Partialdrücke von 15 Pa und von 27 Pa Cl₂ verwendet. Das Ätzen erfolgte bei einer Temperatur des Silizium-Halbleitersubstrats 30 von 20°C, bei einem Gesamtdruck von 27 Pa, 42 Pa oder 54 Pa.

Danach wurde wie in der DE 102 29 037 A1 offenbart, die Hochfrequenz- bzw. Mikrowellenzufuhr zum Plasmareaktor 100 abgeschaltet, die Prozessgaszufuhr gestoppt und die Prozesskammer 10 sowie die Mimik der Gasversorgung mit dem Plasmareaktor 100 leer gepumpt. Zuletzt übernahm die Turbopumpe 60 bei geöffnetem Ventil 50 das Pumpen auf einen möglichst niedrigen Enddruck, beispielsweise besser als 10⁻⁴ Pa. Dabei ist das Regelventil 70 vor der Drehschieberpumpe 80 geschlossen, d.h. die Drehschieberpumpe 80 kann während dieser Zeit als Vorpumpe für die Turbopumpe 60 eingesetzt werden. War der Basisdruck erreicht, wurde der Siliziumwafer in eine angeschlossene Schleusenvorrichtung ausgeladen.

Es konnte festgestellt werden, dass bei einem ClF₃-Partialdruck von 27 Pa und einem Verhältnis der Partialdrücke von ClF₃ zu Cl₂ von 1 : 0,5 die Selektivität nahezu verdoppelt werden konnte, während bei einem Verhältnis der Partialdrücke von ClF₃ zu Cl₂ von 1 : 1 bei einem Gesamtdruck von 54 Pa die Selektivität sogar mehr als verdoppelt werden konnte. Die nachstehende Tabelle 1 verdeutlich diese Ergebnisse:

**Tabelle 1:**

| Beschreibung | Gesamtdruck | p(ClF3) | p(Cl2) | p(Ar) | Selektivität |
|---|---|---|---|---|---|
| | [Pa] | [Pa] | [Pa] | [Pa] | |
| p(ClF₃) | 27 | 27 | 0 | 0 | 1000 |
| p(ClF₃):p(Cl₂) = 1:0,5 | 42 | 27 | 15 | 0 | 1800 |
| p(ClF₃):p(Ar) = 1:0,5 | 42 | 27 | 0 | 15 | 1100 |
| p(ClF₃) | 27 | 27 | 0 | 0 | 1000 |
| p(C)F₃)p(Cl₂) = 1 : 1 | 54 | 27 | 27 | 0 | 2300 |

Obwohl die vorliegende Erfindung vorstehend anhand bevorzugter Ausführungsbeispiele beschrieben wurde, ist sie nicht darauf beschränkt, sondern auf vielfältige Weise modifizierbar.

Bevorzugte Ausgestattungen des erfindungsgemäßen Verfahrens sind mit den nachgeordneten Patentansprüchen beansprucht und werden nachfolgend näher erläutert.

In bevorzugten Ausführungsformen liegt das Verhältnis der Partialdrücke des Ätzgases, vorzugsweise ClF₃, zu dem zugesetzten Gas ausgewählt aus der Gruppe umfassend Cl₂ und/oder HCl im Bereich von ≥ 1 : 5 bis ≥ 5 : 1, bevorzugt im Bereich von ≥ 1 : 2 bis ≤ 4 : 1, vorzugsweise im Bereich von ≥ 1 : 1 bis ≤ 2 : 1.

Das Zusetzen der Gase ausgewählt aus der Gruppe umfassend Cl₂ und/oder HCl weist den Vorteil auf, dass die Silizium-Ätzrate erniedrigt und die SiGe-Ätzrate nicht schädlich beeinflusst oder sogar erhöht werden kann.

Ein besonderer Vorteil kann dadurch zur Verfügung gestellt werden, dass bei unveränderter oder sogar leicht erhöhter Ätzrate für SiGe eine deutlich gesteigerte Selektivität gegenüber Silizium erreicht werden kann. So ist von großem Vorteil, dass die Selektivität des Ätzens von SiGe gegenüber Silizium um einen Faktor im Bereich von ≥ 2 bis ≤ 5, insbesondere um einen Faktor ≥ 2 bis zu einem Faktor ≤ 3 erhöht werden kann. Dies ermöglicht, dass das Selektivitätsverhältnis des Ätzens von SiGe zu Silizium auf über 10000:1 erhöht werden kann, vorzugsweise auf ein Selektivitätsverhältnis im Bereich von 20000:1 bis 30000:1.

Bevorzugte trockenchemische Ätzverfahren sind plasmalose trockenchemische Ätzverfahren. Von Vorteil ist, dass eine Zugabe von Cl₂ und/oder HCl zu dem verwendeten Ätzgas wie ClF₃ und/oder ClF₃. insbesondere in plasmalosen trockenchemischen Ätzverfahren bereits in geringen Mengen, beispielsweise bei einem Verhältnis der Partialdrücke von ClF₃ zu Cl₂ von 2:1, eine Steigerung der Selektivität nahezu um einen Faktor 2 bewirken kann. Beispielsweise kann das Selektivitätsverhältnis von SiGe zu Silizium für einen Germanium-Anteil von beispielsweise 35% und Gasdrücke von Chlor und ClF₃ im Bereich von 0,1 Pa bis 0,5 Pa während des Ätzens von beispielsweise 5000:1 auf über 10000:1 erhöht werden.

Der Partialdruck des zugesetzten Gases ausgewählt aus der Gruppe umfassend Cl₂ und/oder HCl liegt, beispielsweise in einer Prozesskammer, vorzugsweise im Bereich von ≥ 0,5 Pa bis ≤ 500 Pa, bevorzugt im Bereich von ≥ 1 Pa bis ≤ 100 Pa, besonders bevorzugt im Bereich von ≥ 20 Pa bis ≤ 50 Pa.

Der Partialdruck des Ätzgases ausgewählt aus der Gruppe umfassend ClF₃ und/oder ClF₅, vorzugsweise ClF₃, beispielsweise in einer Prozesskammer, in der das Ätzen erfolgt, liegt vorzugsweise im Bereich von ≥ 0,5 Pa bis ≤ 500 Pa, bevorzugt im Bereich von ≥ 1 Pa bis ≤ 100 Pa, besonders bevorzugt im Bereich von ≥ 20 Pa bis ≤ 50 Pa.

Bevorzugt legt der Gesamtgasdruck von Ätzgas und zugesetztem Gas im Bereich von ≥ 0,5 Pa bis ≥ 1000 Pa, vorzugsweise im Bereich von ≥ 1 Pa bis ≥ 200 Pa, bevorzugt im Bereich von ≥ 20 Pa bis ≤ 100 Pa.

Das Zusetzen des Gases ausgewählt aus der Gruppe umfassend Cl₂ und/oder HCl kann beispielsweise erfolgen, indem Cl₂ und/oder HCl in eine Reaktionskammer oder Prozesskammer, in die das Ätzgas zum Ätzen eingeführt wird, zugeführt wird, und/oder dem Ätzgas bereits vor der Reaktionskammer zugesetzt wird, beispielsweise in einer gemeinsamen Zuleitung.

Geeignete Ätzgase, insbesondere das Ätzgas Chlortrifluorid können in handelsüblichen Druckgasflaschen als verflüssigtes Gas bevorratet und daraus gasförmig entnommen werden. Bevorzugt kann vorgesehen sein, dass Chlortrifluorid unmittelbar vor dem Ätzvorgang hergestellt wird, beispielsweise in einer für das Ätzen verwendbaren Prozesskammer zugeordneten Vorrichtung umfassend einen Plasmareaktor, aus der das Chlortrifluorid in die Prozesskammer überführt werden kann.

In einer bevorzugten Ausführungsformen wird das Ätzgas ClF₃ hergestellt, indem in einem Plasmareaktor ein hochdichtes Plasma erzeugt wird, und wobei dem Plasmareaktor ein erstes Gas ausgewählt aus der Gruppe umfassend Cl₂ und/oder HCl und ein zweites Gas ausgewählt aus der Gruppe umfassend NF₃, F₂ und/oder SF₆, vorzugsweise NF₃, zugeführt werden, die unter dem Einfluss eines hochdichten Plasmas in dem Plasmareaktor unter Bildung von Chloilrifluorid miteinander reagieren.

Beispielsweise kann ein Überschuss von Chlor oder HCl in der Plasmaerzeugung von ClF₃ vorgelegt werden. In bevorzugter Weise wird Chlor und/oder Chlorwasserstoff beispielsweise über einen zweiten Massenflussregler, insbesondere unterhalb der Plasmaerzeugung des Ätzgases, beispielsweise ClF₃, dein gebildeten Ätzgas zugeführt, während die Plasmaerzeugung von ClF₃ selbst annähernd stöchiometrisch oder nur mit einem leichten Chlorüberschuss abläuft.

In einer bevorzugten Ausführungsform wird das Gas ausgewählt aus der Gruppe umfassend Cl₂ und/oder HCl dem Ätzgas dadurch zugesetzt, dass dem Plasmareaktor ein Überschuss des ersten Gas ausgewählt aus der Gruppe umfassend Cl₂ und/oder HCl gegenüber dem zweiten Gas, vorzugsweise NF₃, zugeführt wird. Vorzugsweise liegt das Verhältnis der Gasflüsse, das dem Molverhältnis entsprechen kann, von erstem Gas ausgewählt aus der Gruppe umfassend Cl₂ und/oder HCl zu zweitem Gas, vorzugsweise NF₃, in einem Bereich von ≥ 1 : 5 bis ≤ 6 : 1, bevorzugt im Bereich von ≥ 1 : 3 bis ≤ 4 : 1, besonders bevorzugt im Bereich von ≥ 1 : 2 bis ≤ 2 : 1.

Bei dieser Ausführungsform ist insbesondere von Vorteil, dass bei der Bildung des Ätzgases durch den zugesetzten Überschuss von Cl₂ und/oder HCl, gegenüber dem zweiten Gas, vorzugsweise NF₃, während der Reaktion gebildete Fluorradikale vollständig oder nahezu vollständig mit dem Chlorüberschuss abreagieren können. Dies kann den Vorteil zur Verfügung stellen, dass keine oder nahezu keine Fluorradikale die Prozesskammer erreichen, wo sie die Selektivität einer Opferschichtätzung einer Silizium-Germanium-Schicht gegenüber Silizium äußerst nachteilig beeinflussen würden, da sie Silizium-Germanium wie Silizium ohne Unterschied ätzen.

In einer bevorzugten Ausführungsform wird das Gas ausgewählt aus der Gruppe umfassend Cl₂ und/oder HCl₂ dem Ätzgas, vorzugsweise dem gebildeten Chlortrifluorid, zugesetzt, wobei das Ätzgas insbesondere Chlortrifluorid und das Gas ausgewählt aus der Gruppe umfassend Cl₂ und/oder HCl gemeinsam einer Prozesskammer, in der das Ätzen stattfindet, zugeführt werden.

Ein besonderer Vorteil dieser Ausführungsform einer gemeinsamen Zuführung des gebildeten Ätzgases insbesondere ClF₃ und des zugesetzten Chlorgases und/oder Chlorwasserstoffs in eine Prozesskammer weist den Vorteil auf, dass unerwünschte Fluorradikale durch das Chlor oder HCl während einer gemeinsamen Zuführung beispielsweise unter Bildung von Chlorfluorid (ClF) abgefangen werden können.

Bei dieser Ausführungsform ist bevorzugt, dass die Herstellung des ClF₃ beispielsweise unter Verwendung von Chlor bei einem für die Erzeugung von ClF₃ stöchiometrischen oder nahezu stöchiometrischen Verhältnis von NF₃ und Cl₂ zueinander durchgeführt wird. Dies kann den Vorteil zur Verfügung stellen, dass durch ein annähernd stöchiometrisches Verhältnis von NF₃ zu Cl₂, vorzugsweise von ca. 2:1, vermieden werden kann, dass ein zu großer Anteil von Fluorradikalen anstatt zu ClF₃ zu ClF reagiert, welches als Ätzgas für eine Opferschichtätzung ineffektiv wäre. Weiterhin kann durch eine Herstellung von ClF₃ in der Plasmaquelle unter stöchiometrischen Bedingungen vermieden werden, dass im Plasma Chlorradikale im Übermaß generiert werden und ein Teil der zur Verfügung gestellten Plasmaleistung für diese Bildung von Chlorradikalen verbraucht würde, wobei diese für das Ätzen keinen Nutzen erzeugen, das diese aufgrund Ihrer kurzen Lebensdauer einer Rückbildung zu Cl₂ oder einer Reaktion zu nutzlosen Interhalogeniden wie ClF unterliegen.

In einer weiteren Ausführungsform können die Gase ausgewählt aus der Gruppe umfassend Cl₂ und/oder HCl der Prozesskammer getrennt von dem gebildeten Chlortrifluorid zugeführt werden.

Es kann besonders bevorzugt sein, die Möglichkeiten zum Zusetzen von Cl₂ und/oder HCl zu dem Ätzgas zu kombinieren. Vorzugsweise kann zur Herstellung des Ätzgases insbesondere ClF₃ ein stöchiometrisches Verhältnis oder ein nur wenig über dem stöchiometrischen Verhältnis liegender Chlor- oder HCl-Anteil eingestellt werden. Hierbei kann in vorteilhafter Weise bereits bei der Erzeugung von ClF₃ das Entstehen von Fluorradikalen vermindert oder verhindert werden. Weiterhin kann dem hergestellten Ätzgas, insbesondere ClF₃, zusätzlich weiteres Cl₂ und/oder HCl zugesetzt werden, wobei Cl₂ und/oder HCl gemeinsam und/oder getrennt von dem Ätzgas, insbesondere ClF₃ dem Ätzgas, beispielsweise in einer Prozess- oder Reaktionskammer zugeführt werden können.

Es ist besonders bevorzugt, dass die Herstellung des Ätzgases, beispielsweise von ClF₃ unter Verwendung von Chlor, unter für die Erzeugung des Ätzgases stöchiometrischen oder nahezu stöchiometrischen Verhältnis des ersten und zweiten Gases beispielsweise von NF₃ und Cl₂ zueinander durchgeführt wird und dem hergestellten Ätzgas insbesondere ClF₃ zusätzlich weiteres Cl₂ und/oder HCl zugesetzt wird, wobei Cl₂ und/oder HCl gemeinsam mit dem Ätzgas insbesondere ClF₃ zugeführt werden.

Ein weiterer Gegenstand der vorliegenden Erfindung betrifft eine Vorrichtung zur Durchführung des erfindungsgemäßen Verfahrens, wobei einer Vorrichtung zur Herstellung des Ätzgases beispielsweise ClF₃ eine Prozesskammer zugeordnet ist, die über einen Gaseinlass mit dem Plasmareaktor verbunden ist, wobei das Halbleitersubstrat in der Prozesskammer angeordnet und dem von der Vorrichtung zur Erzeugung von Chlortrifluorid erzeugten gasförmigen Chlortrifluorid ausgesetzt ist, wobei die Vorrichtung ein weiteres Gaszufuhrmittel aufweist, das einen weiteren Massenflussregler umfasst, mit der die Zufuhr des Gases ausgewählt aus der Gruppe umfassend Cl₂ und/oder HCl, das dem Plasmareaktor, dem Gasauslass des Plasmareaktors und/oder einem Gaseinlass der Prozesskammer zugeführt wird, einstellbar ist.

Von Vorteil ist, dass das weitere Gaszufuhrmittel, das einen weiteren Massenflussregler umfasst, eine Zuführung des Gases ausgewählt aus der Gruppe umfassend Cl₂ und/oder HCl, das dem Plasmareaktor, dem Gasauslass und/oder der Prozesskammer zugeführt wird, einstellbar ist.

## Patentansprüche

1. Verfahren zum Ätzen einer SiGe-Mischhalbleiterschicht (31) auf einem Silizium-Halbleitersubstrat (30) durch trockenchemisches Ätzen der SiGe-Mischhalbleiterschicht (31) mittels eines Ätzgases ausgewählt aus der Gruppe umfassend ClF₃ und/oder ClF₅, **dadurch gekennzeichnet, dass** man dem Ätzgas ein Gas ausgewählt aus der Gruppe umfassend Cl₂ und/oder HCl zusetzt.

2. Verfahren nach Anspruch 1, **dadurch gekennzeichnet, dass** das Verhältnis der Partialdrücke des Ätzgases, vorzugsweise ClF₃, zu dem zugesetzten Gas ausgewählt aus der Gruppe umfassend Cl₂ und/oder HCl im Bereich von ≥ 1 : 5 bis ≤ 5 : 1, bevorzugt im Bereich von ≥ 1 : 2 bis ≤ 4 : 1, vorzugsweise im Bereich von ≥ 1 : 1 bis ≤ 2 : 1 liegt.

3. Verfahren nach Anspruch 1 oder 2, **dadurch gekennzeichnet, dass** der Partialdruck des zugesetzten Gases ausgewählt aus der Gruppe umfassend Cl₂ und/oder HCl im Bereich von ≥ 0,5 Pa bis ≤ 500 Pa, vorzugsweise im Bereich von ≥ 1 Pa bis ≤ 100 Pa, bevorzugt im Bereich von ≥ 20 Pa bis ≤ 50 Pa, liegt.

4. Verfahren nach einem der vorherigen Ansprüche, **dadurch gekennzeichnet, dass** der Partialdruck des Ätzgases ausgewählt aus der Gruppe umfassend ClF₃ und/oder ClF₅ im Bereich von ≥ 0,5 Pa bis ≤ 500 Pa, vorzugsweise im Bereich von ≥ 1 Pa bis ≤ 100 Pa, bevorzugt im Bereich von ≥ 20 Pa bis ≤ 50 Pa, liegt.

5. Verfahren nach einem der vorherigen Ansprüche, **dadurch gekennzeichnet, dass** der Gesamtgasdruck von Ätzgas und zugesetztem Gas im Bereich von ≥ 0,5 Pa bis ≤ 1000 Pa, vorzugsweise im Bereich von ≥ 1 Pa bis ≤ 200 Pa, bevorzugt im Bereich von ≥ 20 Pa bis ≤ 100 Pa, liegt.

6. Verfahren nach einem der vorherigen Ansprüche, **dadurch gekennzeichnet, dass** das Ätzgas ClF₃ hergestellt wird, indem in einem Plasmareaktor (100) ein hochdichtes Plasma (105) erzeugt wird, und wobei dem Plasmareaktor (100) ein erstes Gas ausgewählt aus der Gruppe umfassend Cl₂ und/oder HCl und ein zweites Gas ausgewählt aus der Gruppe umfassend NF₃, F₂ und/oder SF₆, vorzugsweise NF₃, zugeführt werden, die unter dem Einfluss des hochdichten Plasmas (105) in dem Plasmareaktor (100) unter Bildung von Chlortrifluorid miteinander reagieren.

7. Verfahren nach einem der vorherigen Ansprüche, **dadurch gekennzeichnet, dass** dem Plasmareaktor (100) ein Überschuss des ersten Gas ausgewählt aus der Gruppe umfassend Cl₂ und/oder HCl gegenüber dem zweiten Gas, vorzugsweise NF₃, zugeführt wird, wobei das Verhältnis der Gasflüsse von erstem Gas zu zweitem Gas vorzugsweise in einem Bereich von ≥ 1 : 3 bis ≤ 4 : 1, bevorzugt im Bereich von ≥ 1 : 5 bis ≤ 6 : 1, vorzugsweise im Bereich von ≥ 1 : 2 bis ≤ 2 : 1, liegt.

8. Verfahren nach einem der vorherigen Ansprüche, **dadurch gekennzeichnet, dass** das Gas ausgewählt aus der Gruppe umfassend Cl₂ und/oder HCl dem gebildeten Chlortrifluorid zugesetzt wird, wobei Chlortrifluorid und das Gas ausgewählt aus der Gruppe umfassend Cl₂ und/oder HCl gemeinsam einer Prozesskammer (10), in der der Ätzvorgang stattfindet, zugeführt werden.

9. Verfahren nach einem der einem der vorherigen Ansprüche, **dadurch gekennzeichnet, dass** das Gas ausgewählt aus der Gruppe umfassend Cl₂ und/oder HCl der Prozesskammer (10) getrennt von dem gebildeten Chlortrifluorid zugeführt wird.

10. Vorrichtung (1) zur Durchführung des Verfahren nach einem der vorherigen Ansprüche, wobei einer Vorrichtung (6) zur Herstellung des Ätzgases ClF₃ eine Prozesskammer (10) zugeordnet ist, die über einen Gaseinlass (20) mit dem Plasmareaktor (100) verbunden ist, wobei das Halbleitersubstrat (30) in der Prozesskammer (10) angeordnet und dem von der Vorrichtung (6) zur Erzeugung von Chlortrifluorid erzeugten gasförmigen Chlortrifluorid ausgesetzt ist **dadurch gekennzeichnet, dass** die Vorrichtung ein weiteres Gaszufuhrmittel (23) aufweist, das einen weiteren Massenflussregler (23) umfasst, mit der die Zufuhr des Gases ausgewählt aus der Gruppe umfassend Cl₂ und/oder HCl, die dem Plasmareaktor (100), dem Gasauslass (20) und/oder der Prozesskammer (10) zugeführt wird, einstellbar ist.

## Claims

1. Method for etching an SiGe mixed semiconductor layer (31) on a silicon semiconductor substrate (30) by dry-chemical etching of the SiGe mixed semiconductor layer (31) by means of an etching gas selected from the group comprising ClF₃ and/or ClF₅, **characterized in that** a gas selected from the group comprising Cl₂ and/or HCl is added to the etching gas.

2. Method according to Claim 1, **characterized in that** the ratio of the partial pressures of the etching gas, preferably ClF₃, to the added gas selected from the group comprising Cl₂ and/or HCl is in the range from ≥ 1:5 to ≤ 5:1, preferably in the range from ≥ 1:2 to ≤ 4:1, more preferably in the range from ≥ 1:1 to ≤ 2:1.

3. Method according to Claim 1 or 2, **characterized in that** the partial pressure of the added gas selected from the group comprising Cl₂ and/or HCl is in the range from ≥ 0.5 Pa to ≤ 500 Pa, preferably in the range from ≥ 1 Pa to ≤ 100 Pa, more preferably in the range from ≥ 20 Pa to ≤ 50 Pa.

4. Method according to any of the preceding claims, **characterized in that** the partial pressure of the etching gas selected from the group comprising ClF₃ and/or ClF₅ is in the range from ≥ 0.5 Pa to ≤ 500 Pa, preferably in the range from ≥ 1 Pa to ≤ 100 Pa, more preferably in the range from ≥ 20 Pa to ≤ 50 Pa.

5. Method according to any of the preceding claims, **characterized in that** the total gas pressure of etching gas and added gas is in the range from ≥ 0.5 Pa to ≤ 1000 Pa, preferably in the range from ≥ 1 Pa to ≤ 200 Pa, more preferably in the range from ≥ 20 Pa to ≤ 100 Pa.

6. Method according to any of the preceding claims, **characterized in that** the etching gas ClF₃ is prepared by generating a high-density plasma (105) in a plasma reactor (100), and feeding a first gas selected from the group comprising Cl₂ and/or HCl and a second gas selected from the group comprising NF₃, F₂ and/or SF₆, preferably NF₃, to the plasma reactor (100), these reacting with one another under the influence of the high-density plasma (105) in the plasma reactor (100) to form chlorine trifluoride.

7. Method according to any of the preceding claims, **characterized in that** an excess of the first gas selected from the group comprising Cl₂ and/or HCl relative to the second gas, preferably NF₃, is supplied to the plasma reactor (100), the ratio of the gas flows of first gas to second gas preferably being within a range from ≥ 1:3 to ≤ 4:1, more preferably in the range from ≥ 1:5 to ≤ 6:1, preferably in the range from ≥ 1:2 to ≤ 2:1.

8. Method according to any of the preceding claims, **characterized in that** the gas selected from the group comprising Cl₂ and/or HCl is added to the chlorine trifluoride formed, by supplying chlorine trifluoride and the gas selected from the group comprising Cl₂ and/or HCl together to a processing chamber (10) in which the etching operation takes place.

9. Method according to any of the preceding claims, **characterized in that** the gas selected from the group comprising Cl₂ and/or HCl is supplied to the processing chamber (10) separately from the chlorine trifluoride formed.

10. Apparatus (1) for performance of the method according to any of the preceding claims, an apparatus (6) for preparation of the etching gas ClF₃ being associated with a processing chamber (10) connected via a gas inlet (20) to the plasma reactor (100), the semiconductor substrate (30) being disposed in the processing chamber (10) and being exposed to the gaseous chlorine trifluoride generated by the apparatus (6) for generation of chlorine trifluoride, **characterized in that** the apparatus has a further gas supply means (23) comprising a further mass flow regulator (23) with which the supply of the gas selected from the group comprising Cl₂ and/or HCl which is supplied to the plasma reactor (100), the gas outlet (20) and/or the processing chamber (10) can be adjusted.

## Revendications

1. Procédé de gravure d'une couche de semi-conducteur mixte SiGe (31) appliquée sur un substrat semi-conducteur en silicium (30) par gravure chimique sèche de la couche de semi-conducteur mixte SiGe (31) au moyen d'un gaz de gravure sélectionné dans le groupe comprenant le ClF₃ et/ou le ClF₅, **caractérisé en ce que** l'on ajoute au gaz de gravure un gaz sélectionné dans le groupe comprenant le Cl₂ et/ou le HCl.

2. Procédé selon la revendication 1, **caractérisé en ce que** le rapport des pressions partielles du gaz de gravure, de préférence le ClF₃, au gaz ajouté sélectionné dans le groupe comprenant le Cl₂ et/ou le HCl, se situe dans une plage de ≥ 1:5 à ≤ 5:1, de préférence dans la plage de ≥ 1:2 à ≤ 4:1, et de préférence encore dans la plage de ≥ 1:1 à ≤ 2:1.

3. Procédé selon la revendication 1 ou 2, **caractérisé en ce que** la pression partielle du gaz ajouté sélectionné dans le groupe comprenant le Cl₂ et/ou le HCl se situe dans la plage de ≥ 0,5 Pa à ≤ 500 Pa, de préférence dans la plage de ≥ 1 Pa à ≤ 100 Pa, et de préférence encore dans la plage de ≥ 20 Pa à ≤ 50 Pa.

4. Procédé selon l'une quelconque des revendications précédentes, **caractérisé en ce que** la pression partielle du gaz de gravure sélectionné dans-le groupe comprenant le ClF₃ et/ou le ClF₅ se situe dans la plage de ≥ 0,5 Pa à ≤ 500 Pa, de préférence dans la plage de ≥ 1 Pa à ≤ 100 Pa, et de préférence encore dans la plage de ≥ 20 Pa à ≤ 50 Pa.

5. Procédé selon l'une quelconque des revendications précédentes, **caractérisé en ce que** la pression gazeuse totale du gaz de gravure et du gaz ajouté se situe dans la plage de ≥ 0,5 Pa à ≤ 1000 Pa, de préférence dans la plage de ≥ 1 Pa à ≤ 200 Pa, et de préférence encore dans la plage de ≥ 20 Pa à ≤ 100 Pa.

6. Procédé selon l'une quelconque des revendications précédentes, **caractérisé en ce que** l'on fabrique le gaz de gravure ClF₃ en produisant un plasma à haute densité (105) dans un réacteur à plasma (100) et dans lequel on envoie dans le réacteur à plasma (100) un premier gaz sélectionné dans le groupe comprenant le Cl₂ et/ou le HCl et un deuxième gaz sélectionné dans le groupe comprenant le NF₃, le F₂ et/ou le SF₆, de préférence le NF₃, qui réagissent l'un avec l'autre dans le réacteur à plasma (100), sous l'influence du plasma à haute densité (105), avec formation de trifluorure de chlore.

7. Procédé selon l'une quelconque des revendications précédentes, **caractérisé en ce que** l'on envoie dans le réacteur à plasma (100) un excès du premier gaz sélectionné dans le groupe comprenant le Cl₂ et/ou le HCl par rapport au deuxième gaz, de préférence le NF₃, dans lequel le rapport des flux de gaz du premier gaz au deuxième gaz se situe de préférence dans une plage de ≥ 1:3 à ≤ 4:1, de préférence dans la plage de ≥ 1:5 à ≤ 6:1, et de préférence encore dans la plage de ≥ 1:2 à ≤ 2:1.

8. Procédé selon l'une quelconque des revendications précédentes, **caractérisé en ce que** l'on ajoute le gaz sélectionné dans le groupe comprenant le Cl₂ et/ou le HCl au trifluorure de chlore formé, dans lequel on envoie le trifluorure de chlore et le gaz sélectionné dans le groupe comprenant le Cl₂ et/ou le HCl en commun dans une chambre de traitement (10), dans laquelle l'opération de gravure est effectuée.

9. Procédé selon l'une quelconque des revendications précédentes, **caractérisé en ce que** l'on envoie le gaz sélectionné dans le groupe comprenant le Cl₂ et/ou le HCl à la chambre de traitement (10) séparément du trifluorure de chlore formé.

10. Dispositif (1) pour la mise en oeuvre du procédé selon l'une quelconque des revendications précédentes, dans lequel une chambre de traitement (10), qui est raccordée au réacteur à plasma (100) par une entrée de gaz (20), est associée à un dispositif (6) pour la fabrication du gaz de gravure ClF₃, dans lequel le substrat semi-conducteur (30) est disposé dans la chambre de traitement (10) et est exposé au trifluorure de chlore gazeux produit par le dispositif (6) de production de trifluorure de chlore, **caractérisé en ce que** le dispositif comporte un autre moyen d'arrivée de gaz (23), qui comprend un autre régulateur de flux massique (23) avec lequel on peut régler l'arrivée du gaz sélectionné dans le groupe comprenant le Cl₂ et/ou le HCl, qui est envoyé au réacteur à plasma (100), à la sortie de gaz (20) et/ou à la chambre de traitement (10).
